# EUROPEAN PATENT APPLICATION

(11) **EP 4 823 261 A1**
(43) Date of publication of application: **14.10.2026**
(21) Application number: 26168386.6
(22) Date of filing: 27.03.2026
(51) Int. Cl.: H05K 7/20

(54) **COOLING CABINET**

(30) Priority: 11.04.2025 US 202563787066 P; 21.10.2025 CN 202511507836
(71) Applicant: Lite-On Technology Corporation, Neihu, Taipei 114 (TW)
(72) Inventor: SYU, Duan-You, Taipei 114, Taiwan, R.O.C. (TW); YAO, Cheng-You, Taipei 114, Taiwan, R.O.C. (TW); CHOU, Shih-Kai, Taipei 114, Taiwan, R.O.C. (TW); LIN, Yu-Hsi, Taipei 114, Taiwan, R.O.C. (TW); MAU, Shu-Hua, Taipei 114, Taiwan, R.O.C. (TW)
(74) Representative: dompatent

(57) **Abstract**

A cooling cabinet includes a cabinet body, a side plate, and a plurality of forced convection elements. The cabinet body includes, from top to bottom, a power distribution region, a heat dissipation region and a coolant distribution region. The power distribution region is equipped with a power distribution unit (PDU). The heat dissipation region is equipped with a heat dissipation unit. The coolant distribution region is equipped with a coolant distribution unit (CDU). The side plate is coupled to the cabinet body. A ratio of a volume of the heat dissipation region to an internal volume of the cabinet body is equal to or greater than 75%.

## Description

### Field of the Invention

The invention relates in general to a cooling cabinet.

### Description of the Related Art

To cool high-heat electronic devices, water-cooled cooling cabinets are often required to achieve the desired cooling effect. The design of the heat exchanger and the piping configuration of the cooling cabinet have a significant impact on heat dissipation efficiency.

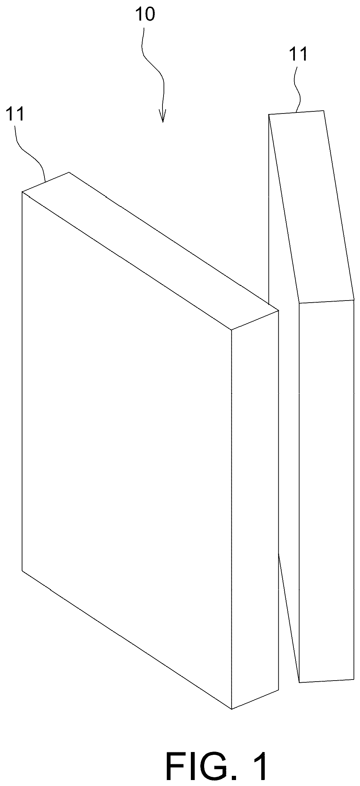

Referring to FIG. 1, FIG. 1 illustrates a partial schematic diagram of a conventional cooling cabinet 10. The cooling cabinet 10 includes at least two radiators 11 arranged in a V-shape. The disadvantages of the V-shaped arrangement includes: low space utilization, uneven air flow, stagnation in local areas, heat accumulation in some areas, and uneven heat dissipation.

Thus, developing cooling cabinets that improve heat dissipation efficiency is one of the goals of companies in this technology field.

### SUMMARY OF THE INVENTION

According to an embodiment of the present invention, a cooling cabinet is provided. The cooling cabinet includes a cabinet body, a lateral plate and a plurality of forced convection elements. The cabinet body is divided, from top to bottom, into a power distribution region, a heat dissipation region and a coolant distribution region. The power distribution region is provided with a power distribution unit (PDU). The heat dissipation region is provided with a heat dissipation unit. The coolant distribution region is provided with a coolant distribution unit (CDU). The lateral plate is coupled to the cabinet body. The plurality of forced convection elements is disposed on the lateral plate. A ratio of a volume of the heat dissipation region to an internal volume of the cabinet body is equal to or greater than 75%.

Based on at least one of the foregoing embodiments, a ratio of a volume of the power distribution region to an internal volume of the cabinet body is equal to or greater than 6%.

Based on at least one of the foregoing embodiments, a ratio of a volume of the coolant distribution region to an internal volume of the cabinet body is equal to or greater than 16%.

Based on at least one of the foregoing embodiments, a ratio of a volume of the heat dissipation unit to the internal volume of the cabinet body is equal to or greater than 15%.

Based on at least one of the foregoing embodiments, the heat dissipation unit includes a plurality of radiators, and each radiator includes at least one heat pipe.

Based on at least one of the foregoing embodiments, the radiators are disposed in parallel.

Based on at least one of the foregoing embodiments, the heat pipes of the radiators extend along an axis direction, and an airflow provided by each forced convection element flows along an airflow direction, and the axis direction is substantially perpendicular to the airflow direction.

Based on at least one of the foregoing embodiments, the heat dissipation region is provided with a liquid inlet pipe, a liquid outlet pipe and at least one first connecting pipe, and the liquid inlet pipe, the liquid outlet pipe, the radiators and the at least one first connecting pipe are fluidically coupled.

Based on at least one of the foregoing embodiments, along a flow direction, each first connecting pipe is disposed between any two adjacent radiators.

Based on at least one of the foregoing embodiments, the number of the first connecting pipes is equal to the number of the radiators minus one.

Based on at least one of the foregoing embodiments, the number of the first connecting pipes is less than the number of the radiators minus one.

Based on at least one of the foregoing embodiments, the heat pipes in the radiators extend along an axis direction, and the at least one first connecting pipe extends along a direction, and the axis direction is substantially perpendicular to the direction.

Based on at least one of the foregoing embodiments, the liquid inlet pipe, the liquid outlet pipe, the radiators and the at least one first connecting pipe are fluidically coupled.

Based on at least one of the foregoing embodiments, the liquid inlet pipe, the liquid outlet pipe and the at least one first connecting pipe are located on a same side of the heat dissipation unit.

Based on at least one of the foregoing embodiments, the liquid inlet pipe has a peripheral surface and a liquid inlet, and the liquid inlet is disposed on the peripheral surface.

Based on at least one of the foregoing embodiments, an inner diameter of one of the first connecting pipes is smaller than an inner diameter of the liquid inlet pipe and an inner diameter of the liquid outlet pipe.

Based on at least one of the foregoing embodiments, the first connecting pipes do not protrude beyond a boundary of the radiators.

Based on at least one of the foregoing embodiments, the heat dissipation unit further includes a second connecting pipe, and the second connecting pipe connects the heat pipes of one of the radiators and the first connecting pipe.

Based on at least one of the foregoing embodiments, the second connecting pipe has the same diameter as that of one of the heat pipes.

Based on at least one of the foregoing embodiments, the second connecting pipe is integrally formed with the heat pipes.

Based on at least one of the foregoing embodiments, the second connecting pipe extends in a direction substantially perpendicular to an extension direction of one of the heat pipes.

Based on at least one of the foregoing embodiments, the cooling cabinet further includes a plurality of first plates, and the first plates connect the heat pipes of the radiators, wherein a bend in one of the heat pipes of the radiators protrudes relative to a surface of the first panel.

Based on at least one of the foregoing embodiments, the heat pipes extend back and forth axially.

Based on at least one of the foregoing embodiments, the heat dissipation region is equipped with a liquid inlet pipe, a first connecting pipe and a liquid outlet pipe. The liquid inlet pipe is connected to one of the radiators and has a liquid inlet disposed on a bottom end of the liquid inlet pipe. The first connecting pipe connects the radiators. The liquid outlet pipe is connected to another of the radiators and has a liquid outlet located at a bottom end of the outlet pipe.

Based on at least one of the foregoing embodiments, the heat dissipation region is provided with a first connecting pipe, and two of the radiators are fluidly coupled in series via a first connecting pipe.

Based on at least one of the foregoing embodiments, the heat dissipation region is equipped with a liquid inlet pipe, a liquid outlet pipe and a first connecting pipe. The liquid inlet pipe connects to one of the radiators, the first connecting pipe connects the radiators, and the liquid outlet pipe connects to another of the radiators. The heat dissipation region further includes a first air release valve. The first air release valve is connected to a top of the liquid inlet pipe, a top of the first connecting pipe or a top of the liquid outlet pipe.

Based on at least one of the foregoing embodiments, the first air release valve is connected to the top of the liquid inlet pipe, the heat dissipation region further includes a second air release valve and a third air release valve. The second air release valve is connected to a top of the first connecting pipe. The third air release valve is connected to a top of the liquid outlet pipe.

Based on at least one of the foregoing embodiments, the coolant distribution unit includes at least one pump module. Each pump module is selectively connected to or disconnected from the heat dissipation unit and includes a pump and a filter. The filter is connected with the pump in series.

Based on at least one of the foregoing embodiments, each pump module further includes a first electrical connector and a first coolant connector. The first electrical connector has a first end surface. The first coolant connector has a second end surface. The coolant dispensing unit further includes a second electrical connector and a second coolant connector. The second electrical connector includes a first protrusion and a first abutting surface, the first protrusion protrudes relative to the first abutting surface. The second coolant connector includes a second protrusion and a second abutting surface, the second protrusion protrudes relative to the second abutting surface. A first distance between the first end surface and the first abutting surface is substantially equal to a second distance between the second end surface and the second abutting surface.

Based on at least one of the foregoing embodiments, the coolant distribution unit and the heat dissipation unit are arranged in an arrangement direction, and the coolant distribution unit and the heat dissipation unit are completely offset along the arrangement direction.

Based on at least one of the foregoing embodiments, the coolant distribution unit includes at least one pump module, a main coolant tank and a plurality of fluid delivery pipes connecting the pump module and the main coolant tank, and the pump module, the main coolant tank, and the fluid delivery pipe are not located within the heat dissipation region.

Based on at least one of the foregoing embodiments, each pump module includes a first quick-disconnect (QD) connector, the coolant distribution unit further includes a second hot- plugging connector, and the first quick-disconnect connector and the second quick-disconnect connector are selectively connected or disconnected.

Based on at least one of the foregoing embodiments, the heat dissipation unit projected onto a plane has a first projected area, the heat dissipation region is provided with an auxiliary cooling unit, the main coolant tank projected onto the plane has a second projected area, and a ratio of the second projected area to the first projected area is not greater than 10%.

Based on at least one of the foregoing embodiments, the heat dissipation region is equipped with a supply tank, the heat dissipation unit projected onto a plane has a first region, the supply tank projected onto the plane has a second region, and the second region do not overlap the first region.

Based on at least one of the foregoing embodiments, the heat dissipation region is disposed between the power distribution region and the coolant distribution region along a height direction.

Based on at least one of the foregoing embodiments, the cabinet body includes a rack, and the heat dissipation region is provided with a supply tank. The supply tank and the rack overlap in an airflow direction of an airflow provided by the forced convection element.

The above and other aspects of the invention will become better understood with regard to the following detailed description of the preferred but non-limiting embodiment (s). The following description is made with reference to the accompanying drawings.

### BRIEF DESCRIPTION OF THE DRAWINGS

FIG. 1 illustrates a partial schematic diagram of a conventional cooling cabinet;
FIG. 2A is a schematic diagram of a cooling cabinet according to an embodiment of the present invention;
FIG. 2B is an exploded view of a cabinet body and its internal structure in FIG. 2A;
FIG. 3 is a schematic diagram of the cooling cabinet in FIG. 2A viewed from the +Z-axis;
FIGS. 4 and 5 are internal schematic diagrams of a heat dissipation region and a coolant distribution region in FIG. 2A at different viewing angles;
FIG. 6 is a schematic diagram of the cooling cabinet in FIG. 4 viewed from the -Y-axis;
FIG. 7 is a water path diagram of the cooling cabinet in FIG. 2A;
FIG. 8A and FIG. 8B are schematic diagrams of a pump module connected to a second electrical connector and a second coolant connector in FIG. 7; and
FIG. 8C is a schematic diagram of the pump module disconnected from the second electrical connector and the second coolant connector in FIG. 8B.

### DETAILED DESCRIPTION OF THE INVENTION

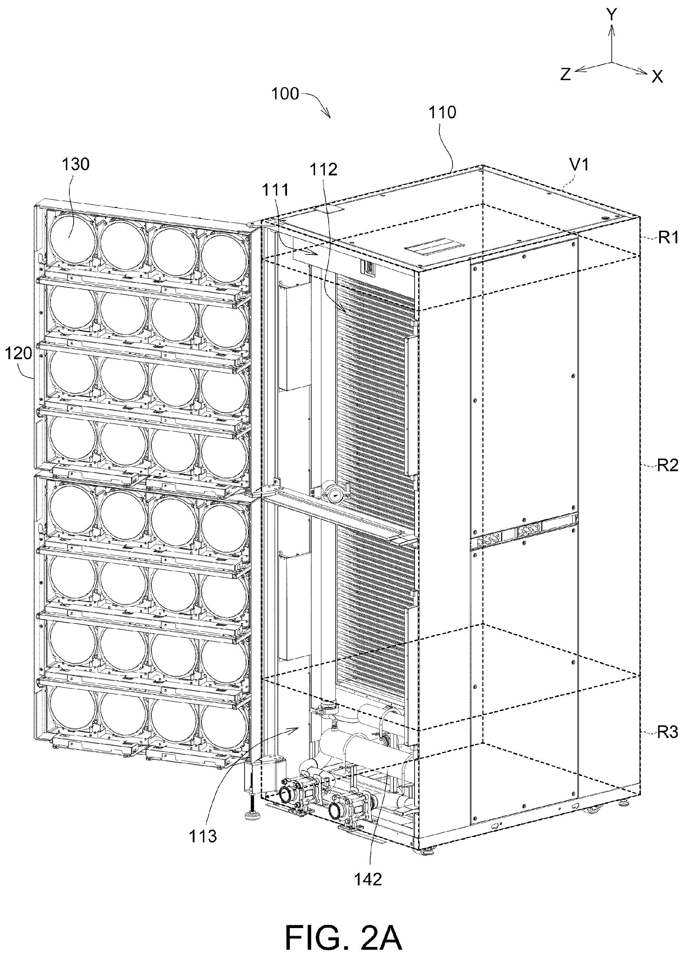

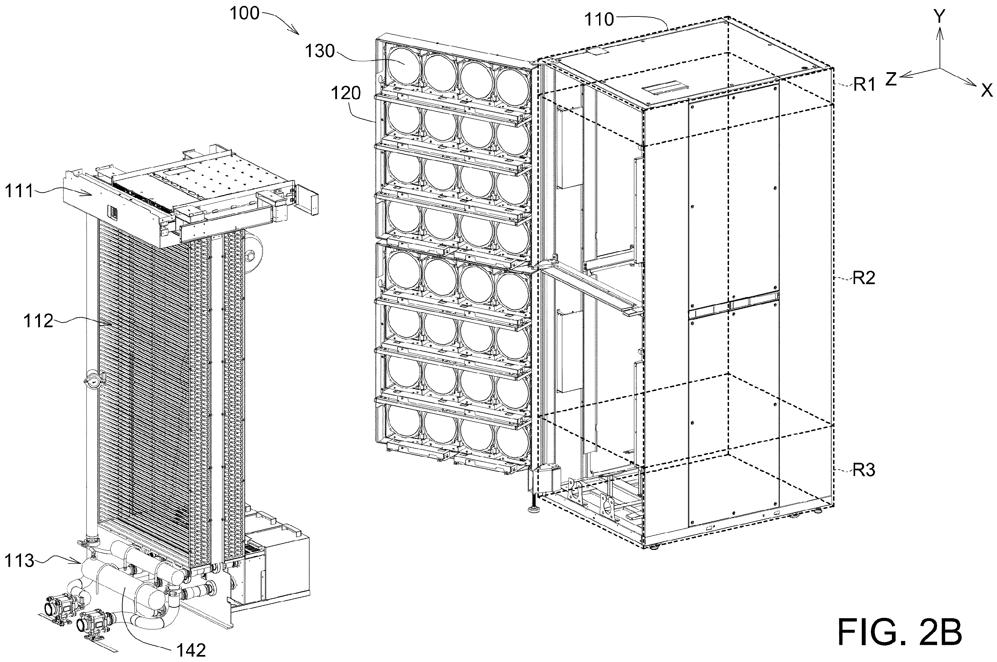

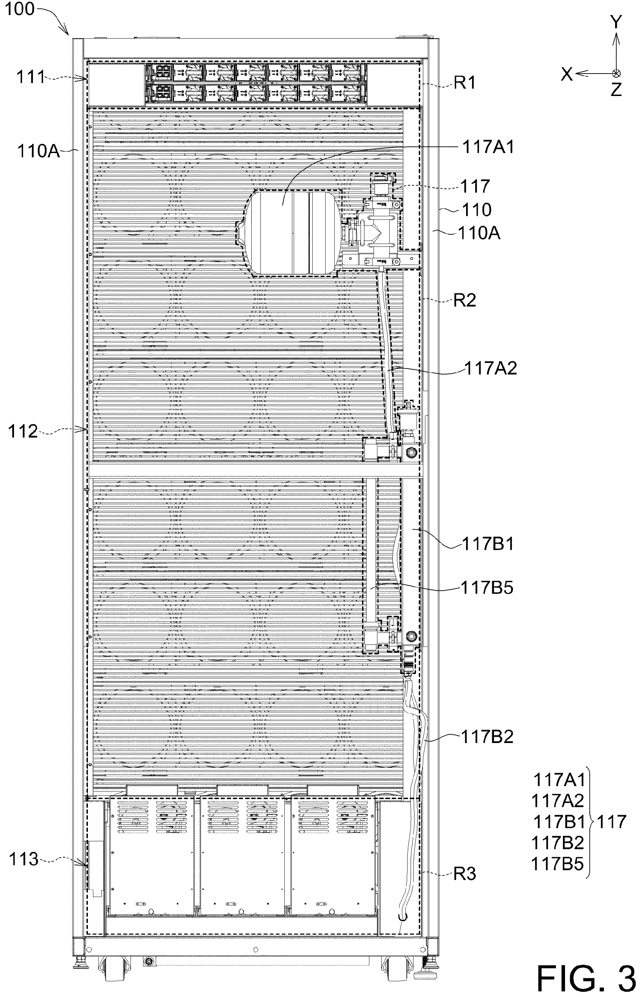

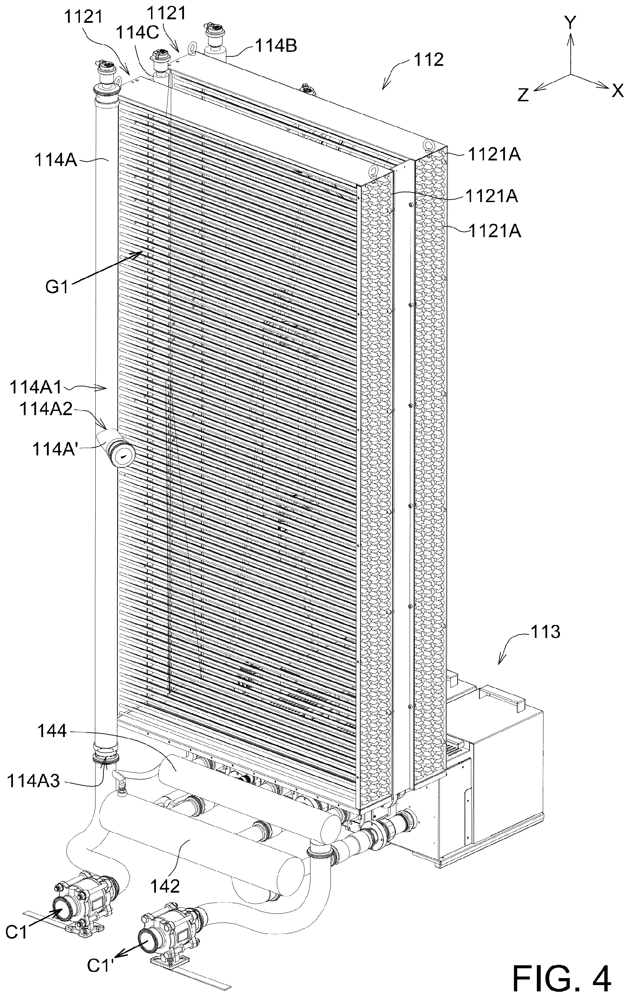

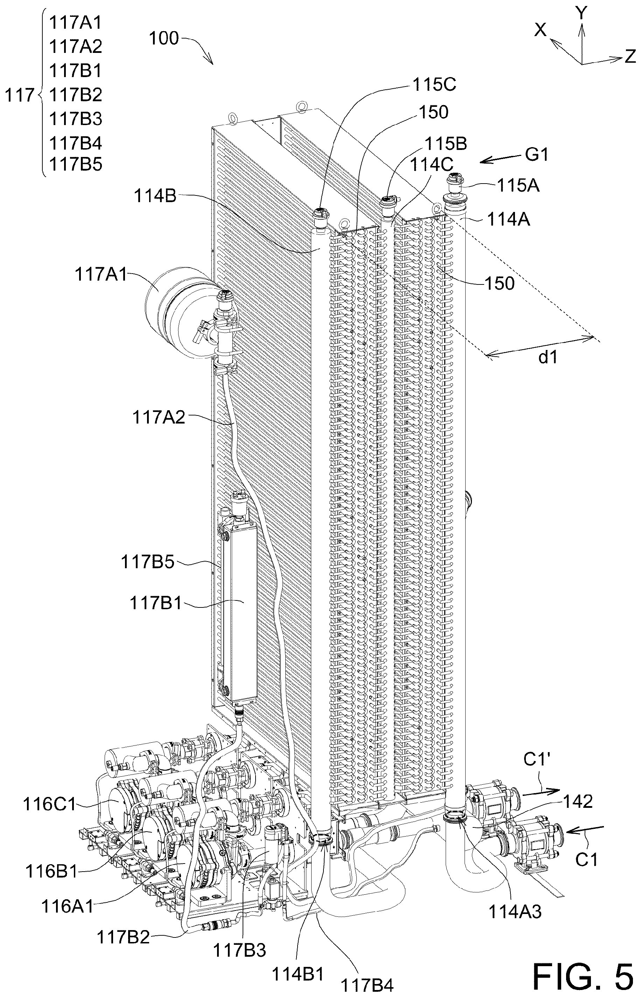

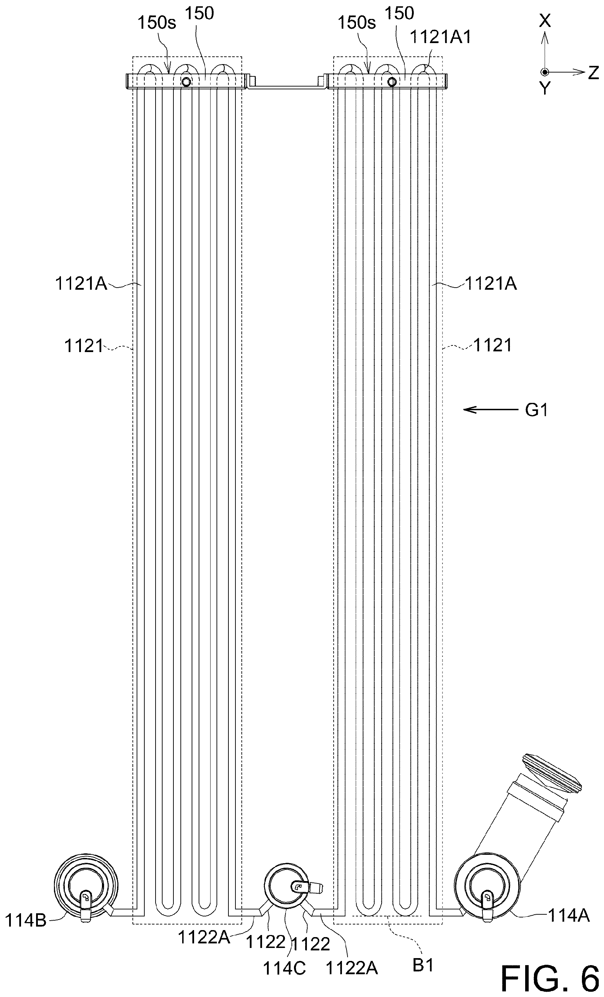

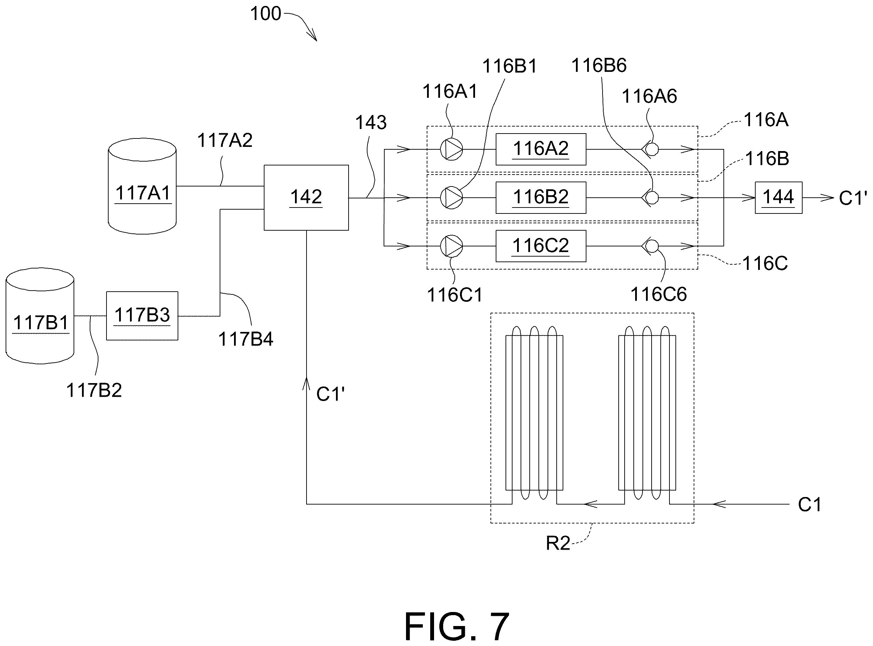

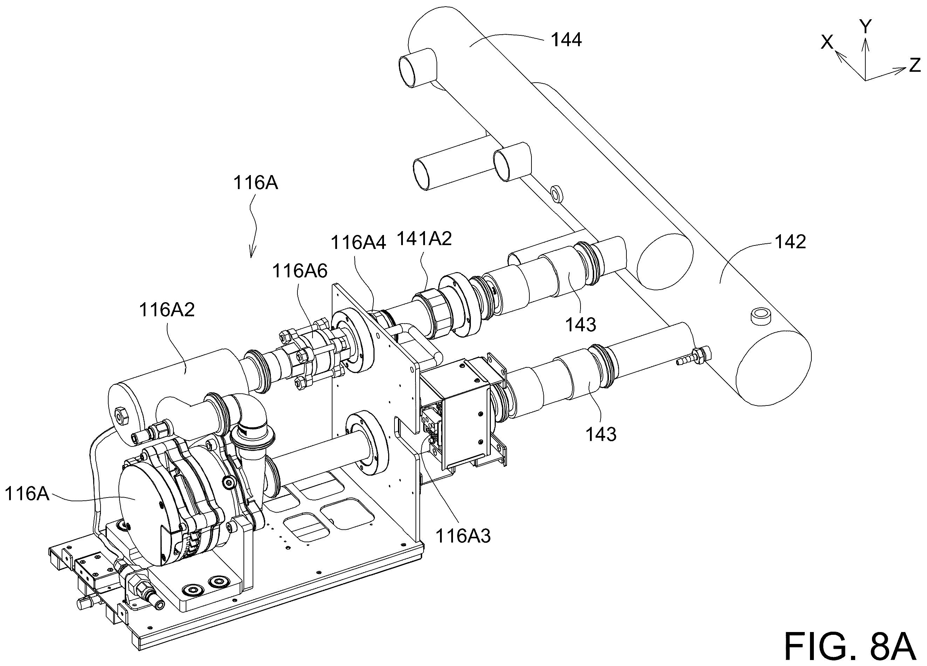

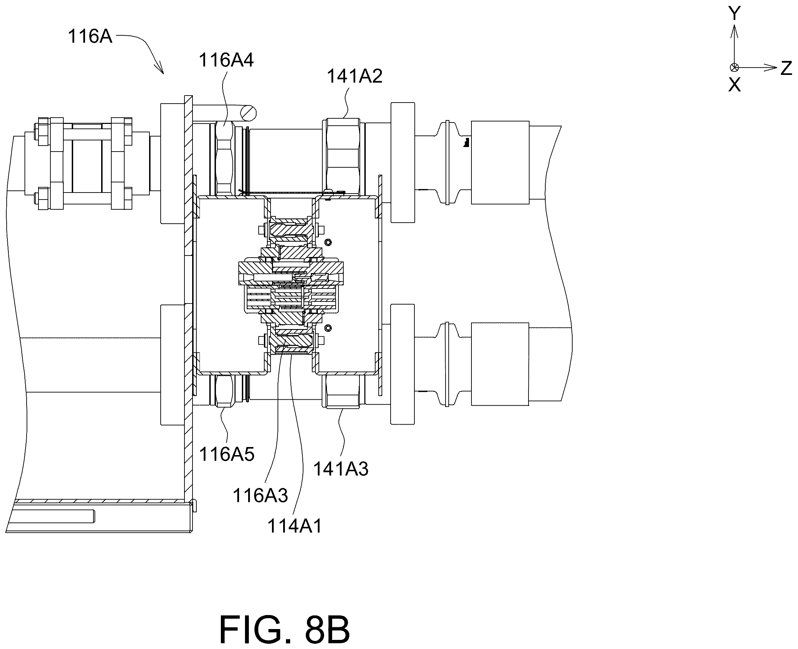

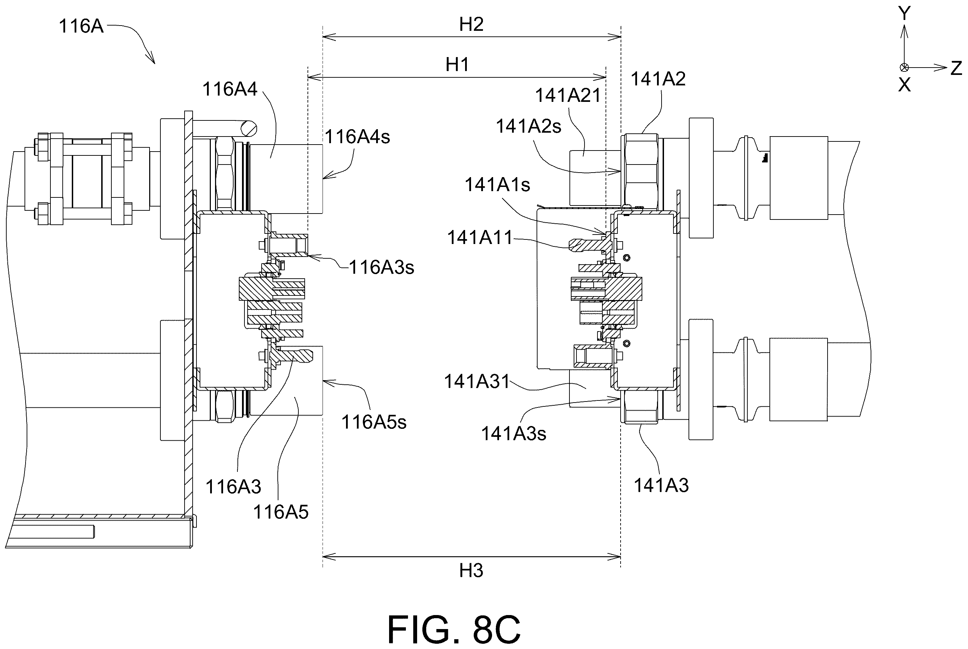

Referring to FIGS. 2A to 8C, FIG. 2A is a schematic diagram of a cooling cabinet 100 according to an embodiment of the present invention, FIG. 2B is an exploded view of a cabinet body 110 and its internal structure in FIG. 2A, FIG. 3 is a schematic diagram of the cooling cabinet 100 in FIG. 2A viewed from the +Z-axis, FIGS. 4 and 5 are internal schematic diagrams of a heat dissipation region R2 and a coolant distribution region R3 in FIG. 2A at different viewing angles, FIG. 6 is a schematic diagram of the cooling cabinet 100 in FIG. 4 viewed from the -Y-axis, FIG. 7 is a water path diagram of the cooling cabinet 100 in FIG. 2A, FIG. 8A and FIG. 8B are schematic diagrams of a pump module 116A connected to a second electrical connector 141A1, a second coolant connector 141A2 and a second coolant connector 141A3 in FIG. 7, and FIG. 8C is a schematic diagram of the pump module 116A disconnected from the second electrical connector 141A1, the second coolant connector 141A2 and the second coolant connector 141A3 in FIG. 8B.

In at least one embodiment, as shown in FIG. 2A and FIG. 2B, the cooling cabinet 100 is configured to cool an electronic device (not shown). The electronic device is, for example, a server, such as a cloud server, an artificial intelligence server, a big data server, a data center, or other high-power or high-heat-generating electronic device.

In at least one embodiment, as shown in FIGS. 2A and 2B, the cooling cabinet 100 includes the cabinet body 110, a lateral plate 120 and a plurality of forced convection elements 130. The cabinet body 110 is divided from top to bottom into a power distribution region R1, the heat dissipation region R2 and the coolant distribution region R3. The power distribution region R1 is provided with a power distribution unit (PDU) 111. The heat dissipation region R2 is provided with the heat dissipation unit 112. The coolant distribution region R3 is provided with a coolant distribution unit (CDU) 113. The lateral plate 120 is connected to the cabinet body 110. The forced convection elements 130 are disposed on the lateral plate 120. A ratio of the volume of the heat dissipation region R2 to the internal volume V1 of the cabinet body 110 may be equal to or greater than 75%, for example, 76%, 77%, 78%, 79%, 80%, or even greater. As a result, the heat dissipation region R2 provides sufficient heat dissipation region or volume, thereby increasing heat dissipation efficiency.

In at least one embodiment, as shown in FIGS. 2A and 2B, the internal volume V1 of the cabinet 110 is substantially equal to the sum of the volume of the power distribution region R1, the volume of the heat dissipation region R2 and the volume of the coolant distribution region R3.

In at least one embodiment, as shown in FIGS. 2A and 2B, the coolant distribution unit 113 and the heat dissipation unit 112 may be arranged linearly along a height direction (e.g., the Y-axis). However, the present invention is not limited thereto. In at least one embodiment, the power distribution region R1, the heat dissipation region R2 and the coolant distribution region R3 may be arranged along a height direction (e.g., the Y-axis) and partially or completely staggered, and accordingly it improves space utilization within the cabinet 110.

In at least one embodiment, as shown in FIGS. 2A and 3, the cabinet 110 includes a rack 110A. When the lateral plate 120 in FIG. 2A is attached to the rack 110A, the lateral plate 120 may abut against the rack 110A or overlap with the rack 110A (e.g., along the XY plane). The rack 110A may not completely overlap at least one of the power distribution region R1, the heat dissipation region R2 and the coolant distribution region R3. Alternatively, the rack 110A may partially overlap at least one of the power distribution region R1, the heat dissipation region R2 and the coolant distribution region R3. In an embodiment, the rack 110A has a third area when projected onto a plane (e.g., a plane parallel to the XY plane), and the heat dissipation region R2 has a fourth area when projected onto this plane. An overlap ratio of the third area to the fourth area ranges, for example, between 0% and 5%. The lower the overlap ratio is, the higher the heat dissipation efficiency is.

In at least one embodiment, as shown in FIGS. 2A and 2B, the forced convection element 130 is, for example, a cooling fan, but the present invention is not limited thereto. Each forced convection element 130 may provide an airflow G1 (the airflow G1 is shown in FIG. 4) flowing along an airflow direction (e.g., the -Z-axis). The airflow G1 flows through the heat dissipation region R2 and carries heat from the heat dissipation region R2 to dissipate heat from the heat dissipation region R2.

In at least one embodiment, as shown in FIGS. 2A and 2B, the ratio of the volume of the power distribution region R1 to the internal volume V1 of the cabinet 110 may be equal to or greater than 6%. As a result, it provides sufficient space for the power distribution unit 111 so that its output power to meet the desired requirements.

In at least one embodiment, as shown in FIGS. 2A and 2B, the power distribution unit 111 located in the power distribution region R1 may convert AC power into DC power to provide power for the electronic elements inside the cooling cabinet 100. In an embodiment, since the DC voltage used in cooling cabinets is usually lower than that of AC voltage and the DC voltage has a less physiological impact on the human body, in the event of an electrical leakage, it can effectively reduce the risk of injury to equipment and people in the vicinity. In an embodiment, the AC is, for example, three-phase AC, and its voltage may range, for example, between 380 volts and 480 volts, while the DC voltage is, for example, 48 volts.

In at least one embodiment, as shown in FIG. 4 , the ratio of the volume of the heat dissipation unit 112 to the internal volume V1 of the cabinet 110 may be equal to or greater than 15%, such as 16%, 17%, 18%, or even greater. As a result, a sufficient ratio may increase the heat dissipation efficiency of the cooling cabinet 100. Furthermore, the heat dissipation capacity of the cooling cabinet 100 is proportional to the area of the radiator (described later) of the heat dissipation unit 112. Therefore, the higher the volume ratio is, the larger the heat dissipation area is and the higher the heat dissipation capacity is.

In at least one embodiment, as shown in FIG. 4, the heat dissipation unit 112 includes a plurality of radiators 1121. Two radiators are used as an example in the present invention. Each radiator 1121 includes at least one heat pipe 1121A. In an embodiment, the radiator 1121 is, for example, an air-to-liquid radiator.

In at least one embodiment, as shown in FIG. 4, the radiators 1121 are arranged in parallel. For example, the extension direction of each radiator 1121 is substantially parallel to the X-axis. Compared to conventional radiators arranged in a V-shape, the radiators 1121 in the present invention are arranged in parallel, and accordingly it may improve the shortcomings of the conventional technology.

In at least one embodiment, as shown in FIGS. 5 and 6, the heat pipe 1121A in each radiator 1121 extends along the X-axis, and the airflow G1 provided by each forced convection element 130 flows along the airflow direction (e.g., the -Z-axis), wherein the X-axis is substantially perpendicular to the airflow direction (e.g., the -Z-axis). Furthermore, due to the radiators 1121 being arranged in parallel, a plurality of flow distances d1 (the flow distance d1 is shown in FIG. 5 and is substantially parallel to the Z-axis) of the airflow G1 traveling through the multiple regions of the two radiators 1121 are substantially equal, the heat dissipation amount of multiple regions of the radiators 1121 are approximately equal (uniform heat dissipation). Compared to conventional V-shaped radiators, the airflow has different flow distances through the multiple regions of the radiator, it results in different heat dissipation amount (uneven heat dissipation) across the multiple regions of the radiator.

In at least one embodiment, as shown in FIGS. 5 and 6, the heat pipe 1121A extends back and forth along the X-axis. For example, the heat pipe 1121A extends along the +X-axis for a certain length, then bends back and extends along the -X-axis for a certain length, and repeats this process several times to form the heat pipe 1121A.

In at least one embodiment, as shown in FIGS. 5 and 6, the plurality of heat pipes 1121A of one of the two radiators 1121 are arranged along the Y-axis and are not directly connected to each other. These heat pipes 1121A of one of the two radiators 1121 (for example, the heat pipe 1121A on the right side of FIG. 6) may be indirectly connected by a first connecting pipe 114C, and the coolant in these heat pipes 1121A is respectively merged into the first connecting pipe 114C, and then the coolant in the first connecting pipe 114C is distributed to the heat pipes 1121A of the other of the two radiators 1121 (for example, the heat pipe 1121A on the left side of FIG. 6).

In at least one embodiment, as shown in FIG. 6 , the cooling cabinet 100 further includes a plurality of first plates 150 connected to the heat pipes 1121A of the radiator 1121, wherein a bending portion 1121A1 of the heat pipes 1121A of the radiator 1121 protrude relative to a surface 150s of the first plates 150.

In at least one embodiment, as shown in FIG. 5, the first connecting pipe 114C does not protrude beyond a boundary B1 of the radiator 1121. Thus, the first connecting pipe 114C is retracted within the radiator 1121, or within the space between the two radiators 1121, and does not occupy space outside the boundary B1 of the radiator 1121 to prevent the first connecting pipe 114C from interfering with the cabinet 110.

In at least one embodiment, as shown in FIGS. 4 and 5 , the heat pipe 1121A of the radiator 1121 extends along the X-axis, while the first connecting pipe 114C extends along a direction (e.g., the Y-axis), wherein the Y-axis is substantially parallel to an extension direction of the first connecting pipe 114C.

In at least one embodiment, as shown in FIGS. 4 and 5, each first connecting pipe 114C is disposed between any two adjacent radiators 1121 along the flow direction (e.g., the -Z-axis). In at least one embodiment, as shown in FIGS. 4 and 5, the number of first connecting pipes 114C is the number of radiators 1121 minus one. For example, when the number of the radiators 1121 is two, the number of the first connecting pipes 114C is one.

In at least one embodiment, the number of the first connecting pipes 114C is less than the number of the radiators 1121 minus one. For example, when the number of radiators 1121 is three, the number of the first connecting pipes 114C may be one, that is, two of the three radiators 1121 are directly connected by the second connecting pipe 1122 described below.

In at least one embodiment, as shown in FIG. 6, the heat dissipation unit 112 further includes a plurality of second connecting pipes 1122. The second connecting pipes 1122 connect the heat pipes 1121A of adjacent radiators 1121 and the first connecting pipe 114C.

In at least one embodiment, as shown in FIG. 6, the second connecting pipes 1122 and the heat pipe 1121A are integrally formed in one piece. For example, a pipe (e.g., a metal pipe) may be bent to form an integrated second connecting pipe 1122 and heat pipe 1121A. However, the present invention is not limited thereto, and the second connecting pipe 1122 and the heat pipe 1121A may be formed by joining different pipes.

In at least one embodiment, as shown in FIG. 6, the extension direction (e.g., the Z-axis direction) of the second connecting pipe 1122 is substantially perpendicular to the extension direction (e.g., the X-axis direction) of the heat pipe 1121A. For example, the second connecting pipe 1122 includes a portion 1122A whose extension direction (e.g., the Z-axis direction) is substantially perpendicular to the extension direction (e.g., the X-axis direction) of the heat pipe 1121A.

In at least one embodiment, as shown in FIG. 6, the second connecting pipe 1122 and the heat pipe 1121A have the same diameter. As a result, it reduce turbulence and excessive flow rate fluctuations. In another embodiment, the second connecting pipe 1122 and the heat pipe 1121A have different diameters.

In at least one embodiment, as shown in FIGS. 4 and 5, the heat dissipation region R2 is provided with a liquid inlet pipe 114A, a liquid outlet pipe 114B and at least one first connecting pipe 114C, wherein the liquid inlet pipe 114A, the liquid outlet pipe 114B, the radiator 1121 and the first connecting pipe 114C are fluidically coupled. In an embodiment, the liquid inlet pipe 114A is configured to transport a high-temperature coolant, and the liquid outlet pipe 114B is configured to transport a low-temperature coolant. Furthermore, the high-temperature coolant C1 (e.g., from a server rack) is transported through the liquid inlet pipe 114A to two second radiators 1121. After traveling through the second radiator 1121, the high-temperature coolant C1 is cooled to a low-temperature coolant C1' which then flows out of the cooling cabinet 100 (e.g., to the server rack) through the liquid outlet pipe 114B.

In at least one embodiment, as shown in FIG. 6, the two radiators 1121 may be fluidically coupled in series by the first connecting pipe 114C. A series water path requires fewer pipes. However, embodiments of the present invention are not limited thereto, and the two radiators 1121 may also be coupled in parallel.

In at least one embodiment, as shown in FIG. 6, the liquid inlet pipe 114A, the liquid outlet pipe 114B and the first connecting pipe 114C are located on the same side of the heat dissipation unit 112. These elements are concentrated on the same side of the cooling cabinet 100 for facilitating maintenance.

In at least one embodiment, as shown in FIG. 6, the inner diameter of the first connecting pipe 114C is smaller than the inner diameter of the liquid inlet pipe 114A and the inner diameter of the liquid outlet pipe 114B. As a result, the flow rate of the coolant in the first connecting pipe 114C may be lower than 1.5 m/s, and accordingly it prevent the metal material (e.g., copper) on the surface from peeling off (which would affect the coolant quality) during long-term operation, and may also reduce the impedance of the heat exchanger (excessively high flow rates will increase the impedance of the heat exchanger). However, the present invention is not limited to this. In another embodiment, the flow rate of the coolant in the first connecting pipe 114C may be equal to or higher than 1.5 m/s.

In at least one embodiment, as shown in FIG. 4, the liquid inlet pipe 114A has a peripheral surface 114A1 and a liquid inlet 114A2. The liquid inlet 114A2 is disposed on the peripheral surface 114A1. The peripheral surface 114A1 is, for example, a lateral surface of the liquid inlet pipe 114A that surrounds a central axis of the liquid inlet pipe 114A, while the liquid inlet 114A2 is a lateral opening of the liquid inlet pipe 114A. In an embodiment, the heat dissipation region R2 is further provided with a connecting pipe 114A' connected to the liquid inlet 114A2. The connecting pipe 114A' is connected to the liquid inlet pipe 114A at an inclined angle for facilitating the coolant to flow through connecting pipe 114A', from top to bottom, into the liquid inlet pipe 114A. As a result, it allows the coolant to flow more quickly into the liquid inlet pipe 114A after entering the connecting pipe 114A'. However, the present invention is not limited to this. In another embodiment, the connecting pipe 114A' may be substantially perpendicular to the liquid inlet pipe 114A.

In at least one embodiment, as shown in FIG. 4, the liquid inlet pipe 114A further includes a liquid inlet 114A3 located at a bottom end of the liquid inlet pipe 114A. The liquid outlet pipe 114B is connected to one of the radiators 1121 and has a liquid outlet 114B1, wherein the liquid outlet 114B1 is located at a bottom end of the liquid outlet pipe 114B. In an embodiment, the liquid inlet 114A3 and the liquid outlet 114B1 are connected to at least one pipeline of the coolant distribution region R3 below. In other words, the high-temperature coolant C1 may enter the heat dissipation region R2 through the pipeline of the coolant distribution region R3, and after being cooled to the low-temperature coolant C1', the low-temperature coolant C1' flows out of the coolant distribution region R3 through the pipeline of the coolant distribution region R3. The "high temperature" and "low temperature" in this article are a relative concept, and its specific temperature value is not limited by the embodiments of the present invention.

In at least one embodiment, the coolant (or working cooling fluid) herein may be one or more of the following: a dielectric fluid (e.g., without water for the purposes of the present disclosure) or water combined with an additive containing at least one dielectric fluid, such as one or more of deionized water, ethylene glycol, and propylene glycol.

In at least one embodiment, as shown in FIG. 6, the heat dissipation region R2 further includes at least one air release valve. The air release valve may be connected to a top of the liquid inlet pipe 114A, a top of the first connecting pipe 114C and/or a top of the liquid outlet pipe 114B. For example, the heat dissipation region R2 further includes a first air release valve 115A, a second air release valve 115B and a third air release valve 115C, wherein the first air release valve 115A is connected to the top of the liquid inlet pipe 114A, the second air release valve 115B is connected to the top of the first connecting pipe 114C, and the third air release valve 115C is connected to the top of the liquid outlet pipe 114B. The air release valve may discharge gas (if any) in the pipe. Due to the air release valve being located at the top of the pipe, it may collect gas in the pipe (gas is light and tends to flow upward).

In at least one embodiment, the ratio of the volume of the coolant distribution region R3 to the internal volume V1 of the cabinet 110 is equal to or greater than 16%. In the present embodiment of the present invention, since the main coolant tank 142 and pump modules (116A, 116B and/or 116C) and other major water path elements are centrally disposed in the coolant distribution region R3, the degree of the major water path elements appearing in the heat dissipation region R2 is reduced (for example, the number of the elements present in the heat dissipation region R2 is reduced and/or the volume of the elements present in the heat dissipation region R2 is reduced), and accordingly it improve the heat dissipation effect.

In at least one embodiment, as shown in FIG. 7, the coolant distribution unit 113 includes at least one pump module, for example, three pump modules 116A, 116B and 116C, less or more. In an embodiment, these pump modules are connected in parallel. As a result, the coolant C1 flowing out of the main coolant tank 142 may enter all pump modules simultaneously. However, in other embodiments, the coolant C1 flowing out of the main coolant tank 142 may enter one or some of all pump modules.

In at least one embodiment, as shown in FIGS. 7 and 8A, the coolant distribution region R3 further includes a centralized box 144 that connects the pump modules to the liquid outlet pipe 114B. The coolant flowing out of the pump modules may be combined in the centralized box 144, then flow through the centralized box 144 to the liquid outlet pipe 114B, and then flow out of the liquid outlet pipe 114B to the outside of the cooling cabinet 100 (the coolant C1' flowing out of the cooling cabinet 100, as shown in FIG. 4).

In at least one embodiment, as shown in FIG. 7, each pump module selectively connects to or disconnects from the heat dissipation unit 112 and includes a pump and a filter, wherein the filter is connected with the pump in series. For example, the pump module 116A includes a pump 116A1, a filter 116A2 and a check valve 116A6, wherein the pump 116A1, the filter 116A2, and the check valve 116A6 are connected in series. The filter 116A2 may filter impurities in the coolant in the water path, while the check valve 116A6 may prevent the coolant in the water path from flowing back to filter 116A2. The pump module 116B include a pump 116B1, a filter 116B2 and a check valve 116B6, wherein the connection relationships among the pump 116B1, the filter 116B2 and the check valve 116B6 are the same as those of the aforementioned pump 116A1, the filter 116A2 and the check valve 116A6, and they will not be further described here. The pump module 116C include a pump 116C1, a filter 116C2 and a check valve 116C6, wherein the connection relationships among the pump 116C1, the filter 116C2 and the check valve 116C6 are the same as those of the aforementioned pump 116A1, the filter 116A2, and the check valve 116A6, and they will not be further described here. In the embodiment of the present invention, since the filter is not disposed in the heat dissipation region R2, the space utilization of the heat dissipation region R2 is improved, and the heat dissipation uniformity and overall efficiency are increased. At the same time, the number of overall pipelines is reduced, making the overall design airflow more clearly layered, reducing pipeline losses, and making filter replacement easier. In addition, since each pump module is equipped with the filter, when the filter of one of these pumps is replaced, the other pumps may continue to operate without affecting the overall operation of the cooling cabinet 100.

In addition, the "water path" herein does not limit the coolant in the pipeline to water.

As shown in FIGS. 8A, 8B, and 8C, the pump module 116A further includes a first electrical connector 116A3 and two first coolant connectors 116A4 and 116A5, and the coolant distribution unit 113 further includes at least one second electrical connector 141A1 and two second coolant connectors 141A2 and 141A3. The pump module 116A and the coolant distribution unit 113 may move relative to each other along the Z-axis until the first electrical connector 116A3 and the second electrical connector 141A1 are connected or disconnected, thereby connecting or disconnecting the electrical circuit between the pump module 116A and the coolant distribution unit 113, and until the first coolant connector (116A4 and 116A5) and the second coolant connector (141A2 and 141A3) are connected or disconnected, thereby connecting or disconnecting the water path between the pump module 116A and the coolant distribution unit 113. In summary, the first electrical connector of the pump module and the second electrical connector of the coolant distribution unit may be selectively connected or disconnected, and/or the first coolant connector of the pump module and the second coolant connector of the coolant distribution unit may be selectively connected or disconnected.

In at least one embodiment, as shown in FIGS. 7 and 8A, the coolant distribution unit 113 further includes a main coolant tank 142 and a plurality of fluid delivery pipes 143 connecting the pump modules (e.g., 116A to 116C) with the main coolant tank 142. All pump modules, the main coolant tank 142, and these fluid delivery pipes 143 may not be located entirely within the heat dissipation region R2.

In at least one embodiment, as shown in FIGS. 8A, 8B, and 8C, the first coolant connector 116A4 is, for example, one of a water inlet connector and a water outlet connector, while the first coolant connector 116A5 is, for example, the other of the water inlet connector and the water outlet connector. The second coolant connector 141A2 of the coolant distribution unit 113 is, for example, one of the water inlet connector and the water outlet connector, while the second coolant connector 141A3 of the coolant distribution unit 113 is, for example, the other of the water inlet connector and the water outlet connector. In the present embodiment, the second coolant connector 141A2 takes the water outlet connector for an example, while the second coolant connector 141A3 takes the water inlet connector for an example. Furthermore, the "water inlet connector" herein is used to receive coolant input, while the "outlet connector" is used to receive coolant output.

In at least one embodiment, the first electrical connector 116A3 and the second electrical connector 141A1 are, for example, hot-plugging connectors. The first coolant connectors 116A4 and 116A5 and the second coolant connectors 141A2 and 141A3 are, for example, quick-disconnect connectors.

In at least one embodiment, the water path between the pump module and the coolant distribution unit and the electrical circuit between the pump module and the coolant distribution unit may be connected or disconnected simultaneously. For example, the water path between the pump module 116A and the coolant distribution unit 113 and the electrical circuit between the pump module 116A and the coolant distribution unit 113 may be connected or disconnected simultaneously. As a result, when replacing the filter 116A2 or repairing the pump 116A1, it is not necessary to disconnect the water path and the electrical circuit separately. Instead, the water path and the electrical circuit may be disconnected simultaneously by simply pulling the pump module 116A out along the -Z-axis (for example, from the connected state in FIG. 8B to the disconnected state in FIG. 8C).

In at least one embodiment, as shown in FIGS. 8A, 8B and 8C, the first electrical connector 116A3 of the pump module 116A has a first end surface 116A3s, the first coolant connector 116A4 has a second end surface 116A4s, and the first coolant connector 116A5 has a second end surface 116A5s. The second electrical connector 141A1 includes a first protrusion 141A11 and a first abutting surface 141A1s, wherein the first protrusion 141A11 protrudes relative to the first abutting surface 141A1s. The second coolant connector 141A2 includes a second protrusion 141A21 and a second abutting surface 141A2s, wherein the second protrusion 141A21 protrudes relative to the second abutting surface 141A2s, and the second coolant connector 141A3 includes a second protrusion 141A31 and a second abutting surface 141A3s, wherein the second protrusion 141A31 protrudes relative to the second abutting surface 141A3s. A first distance H1 between the first end surface 116A3s and the first abutting surface 141A1s is substantially equal to a second distance H2 between the second end surface 116A4s and the second abutting surface 141A2s, and the first distance H1 between the first end surface 116A3s and the first abutting surface 141A1s is substantially equal to a third distance H3 between the second end surface 116A5s and the second abutting surface 141A3s. As a result, the water path between the pump module 116A and the coolant distribution unit 113 and the electrical circuit between the pump module 116A and the coolant distribution unit 113 may be connected or disconnected simultaneously.

In at least one embodiment, the pump module 116B includes structures the same as or similar to that of the pump module 116A, and the coolant distribution unit 113 further includes structures the same as or similar to that of the aforementioned second electrical connector 141A1 and second coolant connectors 141A2 and 141A3 for connection to the pump module 116B, and they will not be repeated herein. The pump module 116C includes structures the same as or similar to that of the pump module 116A, and the coolant distribution unit 113 further includes the structures the same as or similar to that of the aforementioned second electrical connector 141A1 and second coolant connectors 141A2, and 141A3 for connection to the pump module 116C, and they will not be repeated herein.

In at least one embodiment, as shown in FIGS. 2A and 2B, the region of the heat dissipation unit 112 projected onto a plane (e.g., a plane parallel to the XY plane) has a first projected area, and a cooling auxiliary unit 117 (the specific elements of the cooling auxiliary unit 117 are shown in FIGS. 3 and 4) is provided in the heat dissipation region R2. The region of the cooling auxiliary unit 117 projected onto the plane has a second projected area. The ratio of the second projected area to the first projected area is no greater than 10%. As a result, it may reduce airflow resistance, improve heat dissipation uniformity and improve overall performance.

In at least one embodiment, as shown in FIGS. 4, 5, and 7, the auxiliary cooling unit 117 includes a first coolant tank 117A1 and a fluid delivery pipe 117A2. The fluid delivery pipe 117A2 connects the first coolant tank 117A1 with the main coolant tank 142. In an embodiment, the first coolant tank 117A1 is, for example, an expansion tank (e.g., an expansion water tank). The coolant in the expansion tank may regulate pressure and temperature fluctuations at the coolant output end of the pump, and accordingly it stabilizes the coolant pressure.

In at least one embodiment, as shown in FIGS. 5 and 7, the cooling auxiliary unit 117 further includes a second coolant tank 117B1, a liquid delivery pipe 117B2, a supplement pump (or water supplement pump) 117B3, a liquid delivery pipe 117B4 and a liquid level gauge 117B5. The supplement pump 117B3 connects the second coolant tank 117B1 with the supplement pump 117B3, and the liquid delivery pipe 117B4 connects the supplement pump 117B3 with the main coolant tank 142. The second coolant tank 117B1 is, for example, a supply tank (or water tank) that may replenish the coolant in main coolant tank 142. For example, when the coolant in main coolant tank 142 is insufficient, the supplement pump 117B3 may draw coolant from the second coolant tank 117B1 into the main coolant tank 142. The liquid level gauge 117B5 is connected to the second coolant tank 117B1 and may display the coolant level in the second coolant tank 117B1.

In at least one embodiment, as shown in FIGS. 2A, 2B and 3, the heat dissipation unit 112 has a first region when projected onto a plane (e.g., a plane parallel to the XY plane), and the second coolant tank 117B1 has a second region when projected onto the plane. The second region does not overlap with the first region. For example, the second region does not overlap with the first region at all, or the overlapping region is less than a certain ratio, such as 5% or less. As a result, it may reduce airflow resistance, improve heat dissipation uniformity and improve overall performance. In addition, when the lateral plate 120 is closed on (covers) the cabinet body 110, the second coolant tank 117B1 (e.g., a supply tank) overlaps with the rack 110A along the direction (e.g., along the -Z-axis) of the airflow G1 provided by the forced convection element 130.

In at least one embodiment, when the lateral plate 120 of FIG. 2A is closed over the cabinet 110, the second coolant tank 117B1 within the heat dissipation region R2 and the rack 110A may at least partially overlap along the direction of the airflow G1 provided by the forced convection element 130. As a result, it may reduce interference with the airflow by the second coolant tank 117B1. Furthermore, the overlap between the second coolant tank 117B1 and the rack 110A along the direction of the airflow G1 provided by the forced convection element 130 may reduce the overlapping area between the second coolant tank 117B1 and the heat dissipation region R2 along the direction of the airflow G1 provided by the forced convection element 130, and accordingly it reduces interference with the airflow by the second coolant tank 117B1.

While the invention has been described by way of example and in terms of the preferred embodiment (s), it is to be understood that the invention is not limited thereto. Based on the technical features embodiments of the present invention, a person ordinarily skilled in the art will be able to make various modifications and similar arrangements and procedures without breaching the spirit and scope of protection of the invention. Therefore, the scope of protection of the present invention should be accorded with what is defined in the appended claims.

## Claims

1. A cooling cabinet (100), **characterized in that** the cooling cabinet (100) comprises:
a cabinet body (110), divided from top to bottom into:
a power distribution region (R1), provided with a power distribution unit (PDU) (111);
a heat dissipation region (R2), provided with a heat dissipation unit (112); and
a coolant distribution region (R3), provided with a coolant distribution unit (CDU) (113);
a lateral plate (120), coupled to the cabinet body (110);
a plurality of forced convection elements (130), disposed on the lateral plate (120);
wherein a ratio of a volume of the heat dissipation region (R2) to an internal volume (V1) of the cabinet body (110) is equal to or greater than 75%.

2. The cooling cabinet (100) according to claim 1, **characterized in that** a ratio of a volume of the heat dissipation unit (112) to the internal volume (V1) of the cabinet body (110) is equal to or greater than 15%.

3. The cooling cabinet (100) according to and of claims 1 and 2, **characterized in that** the heat dissipation unit (112) comprises a plurality of radiators (1121), the radiators (1121) are disposed in parallel, and each of the radiators (1121) comprises at least one heat pipe (1121A).

4. The cooling cabinet (100) according to any of claims 1 to 3, **characterized in that** the at least one heat pipe (1121A) of the radiators (1121) extend along an axis direction, and an airflow provided by each of the forced convection elements (130) flows along an airflow direction, and the axis direction is substantially perpendicular to the airflow direction.

5. The cooling cabinet (100) according to any of claims 1 to 4, **characterized in that** the heat dissipation region (R2) is provided with a liquid inlet pipe (114A), a liquid outlet pipe (114B) and at least one first connecting pipe (114C); the liquid inlet pipe (114A), the liquid outlet pipe (114B), the radiators (1121) and the at least one first connecting pipe (114C) are fluidically coupled.

6. The cooling cabinet (100) according to any of claims 1 to 5, **characterized in that** the number of the at least one first connecting pipe (114C) is less than or equal to the number of the radiators (1121) minus one.

7. The cooling cabinet (100) according to any of claims 1 to 6, **characterized in that** the at least one heat pipe (1121A) in the radiators (1121) extend along an axis direction, and the at least one first connecting pipe (114C) extends along a direction, and the axis direction is substantially perpendicular to the direction.

8. The cooling cabinet (100) according to any of claims 1 to 7, **characterized in that** the liquid inlet pipe (114A), the liquid outlet pipe (114B), the radiators (1121) and the at least one first connecting pipe (114C) are fluidically coupled in series.

9. The cooling cabinet (100) according to any of claims 1 to 8, **characterized in that** the liquid inlet pipe (114A), the liquid outlet pipe (114B) and the at least one first connecting pipe (114C) are located on a same side of the heat dissipation unit (112).

10. The cooling cabinet (100) according to any of claims 1 to 9, **characterized in that** an inner diameter of the at least one first connecting pipe(114C) is smaller than an inner diameter of the liquid inlet pipe (114A) and an inner diameter of the liquid outlet pipe (114B).

11. The cooling cabinet (100) according to any of claims 1 to 10, **characterized in that** the at least one first connecting pipe (114C) does not protrude beyond a boundary (B1) of the radiators (1121).

12. The cooling cabinet (100) according to any of claims 1 to 11, **characterized in that** the coolant distribution unit (113) comprises at least one pump module (116A, 116B and/or 116C), a main coolant tank (142) and a plurality of fluid delivery pipes (143) connecting the at least one pump module (116A, 116B and/or 116C) and the main coolant tank (142); the at least one pump module (116A, 116B and/or 116C), the main coolant tank (142) and the fluid delivery pipes (143) are not located within the heat dissipation region (R2).

13. The cooling cabinet (100) according to any of claims 1 to 12, **characterized in that** each of the at least one pump module (116A, 116B and/or 116C) comprises a first quick-disconnect (QD) connector, the coolant distribution unit (113) further comprises a second quick-disconnect connector, and the first quick-disconnect connector and the second quick-disconnect connector are selectively connectable and disconnectable.

14. The cooling cabinet (100) according to any of claims 1 to 13, **characterized in that** the heat dissipation unit (112) projected onto a plane has a first projected area, the heat dissipation region (R2) is provided with an auxiliary cooling unit, a main coolant tank (142) projected onto the plane has a second projected area, and a ratio of the second projected area to the first projected area is not greater than 10%.

15. The cooling cabinet (100) according to any of claims 1 to 14, **characterized in that** the heat dissipation region (R2) is equipped with a supply tank (117B1), the heat dissipation unit (112) projected onto a plane has a first region, the supply tank (117B1) projected onto the plane has a second region, and the second region do not overlap the first region.
